(19) Europäisches Patentamt
European Patent Office
Office européen des brevets

(11) Publication number: **0 212 521 B1**

# (12) EUROPEAN PATENT SPECIFICATION

(45) Date of publication of patent specification: **29.05.91** (51) Int. Cl.⁵: **H01L 23/48**, H01L 23/31

(21) Application number: **86111059.1**

(22) Date of filing: **11.08.86**

## (54) Package for integrated circuit.

(30) Priority: **10.08.85 JP 122952/85 U**

(43) Date of publication of application:
**04.03.87 Bulletin 87/10**

(45) Publication of the grant of the patent:
**29.05.91 Bulletin 91/22**

(84) Designated Contracting States:
**DE FR GB**

(56) References cited:
**EP-A- 0 074 817**
**EP-A- 0 090 608**
**FR-A- 2 360 174**
**US-A- 4 465 898**

(73) Proprietor: **FUJITSU LIMITED**
**1015, Kamikodanaka Nakahara-ku**
**Kawasaki-shi Kanagawa 211(JP)**

(72) Inventor: **Tsuji, Kazuto Fujitsu Ltd. Patent Department**
**Kosugi Fujitsu Building 1812-10**
**Shimonumabe**
**Nakahara-ku Kawasaki-shi Kanagawa 211(JP)**
Inventor: **Aoki, Tsuyoshi Fujitsu Ltd. Patent Department**
**Kosugi Fujitsu Building 1812-10**
**Shimonumabe**
**Nakahara-ku Kawasaki-shi Kanagawa 211(JP)**
Inventor: **Ono, Michio Fujitsu Ltd. Patent Department**
**Kosugi Fujitsu Building 1812-10**
**Shimonumabe**
**Nakahara-ku Kawasaki-shi Kanagawa 211(JP)**
Inventor: **Sugiura, Rikio Fujitsu Ltd. Patent Department**
**Kosugi Fujitsu Building 1812-10**
**Shimonumabe**
**Nakahara-ku Kawasaki-shi Kanagawa 211(JP)**

(74) Representative: **Greenstreet, Cyril Henry et al**
**Haseltine Lake & Co. Hazlitt House 28 Southampton Buildings Chancery Lane**
**London WC2A 1AT(GB)**

**EP 0 212 521 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

This invention relates to a package for semiconductor integrated circuits. More particularly, this invention relates to an improvement of a plastic package for integrated circuits, which is provided with leads bent in a J-shape and extending over protuberances formed on each edge of the bottom side of the enclosure, and is generally called a PCC (Plastic Chip Carrier) or PLCC (Plastic Leaded Chip Carrier).

In order to meet the increasing demands for higher density of mounting LSI (Large Scale Integrated circuits) at lower cost on a printed circuit board for electronic equipments, many types of packages for LSI have been developed. Among these developments, the PLCC has been found so promising that the outlines are standardized by JEDEC (Joint Electron Device Engineering Council) entitled "PLASTIC CHIP CARRIER (PCC) FAMILY .050 LEADSPACING, SQUARE, SOLDER MOUNT" (hereinafter referred to as PLCC), because of its advantages, such as small occupation space, inexpensiveness, ease of handling, low thermal resistance, well-matched thermal expansion coefficient to that of the printed circuit board and stress absorption characteristics by the J-shaped leads. The structure of the PLCC is schematically illustrated in FIG. 1 through 3. The main body 11 of the PLCC encapsulating an LSI with plastic resin has the shape of an essentially flat box, which has a relatively wide top and bottom and four relatively low lateral sides 23, two of which are in the plane of the paper and therefore not shown. In a strict sense of description, each lateral side generally consists of an upper-half lateral side 23' and a lower-half lateral side 23". Each half lateral side extends from the mid point of the above-described lateral side 23 slanted back from the plane 24 of the lateral side by 3° (denoted by U in FIG. 2) toward the top 11-2 and bottom 11-1 of the enclosure. The lateral side plane 24 represents a lateral side of the above-mentioned flat box orthogonal to the top and bottom of the box. On the bottom surface 11-1 of the flat box, there are provided a plurality of protuberances 17 which are lined up along and parallel to the the lateral side. The protuberances are spaced along the lateral side by 1.27 mm, the width of each protuberance along the lateral side is 0.8 mm, the width of the base of each protuberance orthogonal to above described width is 0.7mm, and the height of the protuberances from the bottom surface 11-1 of the flat box is about 0.6 mm. Each protuberance has a first slope 20 (FIG. 2) coplanar with each slanted lower-half lateral side 23. Each protuberance has a rounded top 21 from the first slope to a second slope 22 which has an angle of approximately 25° (denoted by V in FIG. 2) with respect to each lateral side plane 24. As for the structure of leads, through four lateral sides of the flat box plurality of electrically conductive leads 12 are extended from the enclosure toward the outside, while another end of each lead is connected by a bonding wire 14 to the corresponding terminal pad of the LSI 13 encapsulated in the main body 11. Material of the leads is copper alloy for its good thermal conductivity. Immediately after extending out of the lateral side, each lead is bent and extends along and approximately parallel to each lateral side toward the bottom of the box. Each lead then extends along and curves like a J-shape around its associated protuberance toward the bottom 11-1 of the box. There is a second type of PLCC as an optional variation of the above described first type. The difference of the second type from the first type is that the gaps 18 between the prior art protuberances 17 are fully filled with the same plastic material to form a continuous bank 17' of a uniform height along each lateral side as shown in FIG. 6. Details of the PLCC are also disclosed in U.S.Pat.No.4,465,898 entitled "Carrier for Integrated Circuit", John W. Orcutt, et al. issued on Aug. 14, 1984 and No.4,495,376 entitled "Carrier for Integrated Circuit", Angus W. Hightower, et al. issued on Jan. 22, 1985.

Soldering of PLCC upon a printed circuit board 10 is typically done by a reflow method, which has been widely used in the electronic industry. The reflow method is as follows. Solder-paste (mixture of powdered solder, soldering flux and binder) is printed on specific portions of printed copper leads 16 by the silk screen method. Many types of the solder-paste are available on market. Among them, solder of 63Sn-37Pb alloy is most popularly used. As for the flux, rosin type is typically used. To control chlorine contents in the flux, MIL-RMA type is preferably used. The thickness of the printed solder-paste is generally 200--300 $\mu$m. A PLCC is placed on a printed circuit board so that each roundly formed lead of the PLCC sits exactly on a corresponding deposit of printed solder-paste. The printed circuit board carrying the pasted PLCC thereon is heated by heating means, such as an infrared lamp or vapor-phase, enough for the solder paste to melt, for example 220--235° C for 40 sec maximum in case of infrared lamp heating. The printed circuit board, the PLCC and the melted solder are cooled to solidify the solder. The solidified solder is denoted by 15 in FIG. 1.

Next, in order to remove undesirably remaining flux on the printed circuit board and the PLCC, they are washed by dipping or boiling in a solvent, such as tri-chloroethylene, freon etc.. If removal of the flux is not sufficient, the remaining flux may corrode the leads 16 of printed circuit board or leads 12 of the PLCC resulting in its disconnection, because they are made of copper or copper alloy either of which is very susceptible to the acid in the flux. So, the washing must be always done perfectly. However, the gap 25 between the curved lead and the associated protuberance is located just behind the soldered portion 15 of the lead and the flux is apt to invade there though the gap is narrow, because the flux is apt to explodingly splash by the heat for the soldering. Therefore, the first type of PLCC is provided with gaps, i.e. channels 18 between protuberances as the path of flowing solvent so that the solvent can flow smoothly to and from the soldered portion 15, and the adjoining narrow gap 25. Flux removal is thereby facilitated.

However, there are some problems in the prior art types of PLCC. A problem of the first type PLCC is that the protuberances are so thin in width that they are easy to break, because during the ejection of the hardened plastic resin from the molding cavities there may be produced a chip or crack on the protuberance. In practice, numerous PLCCs are made by plastic molding at the same time to improve production efficiency. Also, the side walls 27 facing each other of the protuberances 17 are parallel and orthogonal to the bottom surface 11-1 of the PLCC (FIG. 4). 31 denotes a molding cavity. Therefore, if all the molded PLCCs are ejected exactly parallel along the side walls 27 from the mold cavities 31, no lateral stress is imposed against the side walls 27 of the protuberance 17. However, in practical operation, some non-parallel motion of ejection of the PLCCs from the cavities is unavoidable and this non-parallel motion causes the above-described lateral stress against the side walls of the protuberances. This lateral stress may cause a crack on the protuberance. In order to ease this lateral stress on the parallel wall 27, the parallel wall 27 of each protuberance can be slanted as shown by the broken lines in FIG. 5. 31' denotes a molding cavity. However, if the slanted walls are designed to provide a relatively wide bottom portion of the channel 18, the slanted walls are apt to make a sharp edge at the top of the protuberance as shown by the broken lines A, allowing the sharp top easily to crack, so easily to hurt fingers of a handler. If the slanted walls are designed to provide a relatively wide top of the protuberance, the slanted walls are apt to make a narrow bottom of the channel 18 as shown by the broken lines B, and flux remaining therein can not be easily removed. Summing up the problems described above about the first type of PLCC, determination of the shape of the protuberance is very delicate and difficult.

A problem with the second type of PLCC, in which the channel 18 between adjacent protuberances 17 is absent in order to strengthen the breakably weak protuberances, is that the solvent cannot flow smoothly to and from the flux remaining in the gap 25 (FIG. 6) of about 70 micron between the curved lead and the top 25 of the protuberance 17'. Thus, the remaining flux cannot be perfectly removed. Therefore, a PLCC having a structure satisfying the requirements of both mechanical strength of the protuberances and completeness of flux removal has been seriously in demand.

Embodiments of the present invention can provide a PLCC having protuberances which are mechanically strong while enabling solvent to remove remaining flux perfectly. They can also provide a PLCC having protuberances which obviate the risk of hurting a handler of the PLCC.

One embodiment of the invention comprises a package for an integrated circuit comprising:

(a) an enclosure having said integrated circuit located therein, and having a top, bottom, and four lateral sides, said bottom side being provided with a plurality of protuberances, said protuberances being aligned along each lateral side, and being spaced from and connected to adjacent protuberances by an interconnector by a predetermined distance, said interconnector being made of the same material as said enclosure and swelling out of said bottom side and having a height less than the height of said protuberances measured from said bottom side; and

(b) a plurality of leads, a first end of each lead being connected to a terminal pad of said integrated circuit encapsulated in said enclosure, a second end of each lead extending through said each lateral side and further along said lateral side toward said bottom, and each of said ends further extending over and curving around each of said protuberances toward said bottom side. The height of said interconnector is from one third to two thirds of the height of said protuberances measured from said bottom side.

The present invention thus provides a PLCC having protuberances each of which is connected to an adjacent protuberance by an interconnector which is swelling out of the bottom surface of the enclosure of PLCC but of which the height is lower than that of the protuberance. The height of the swelling is one third to two thirds of that of the prior art protuberance. The interconnector may be made of the same plastic material as the main body of the enclosure and molded at the same time as the injection molding of the enclosure. According to the prior art structure of the protuberance, its leg portion, the portion adjoining the bottom surface of the main body, is the place where the lateral stress caused by the non-parallel motion of ejection is biggest and where it is most likely to be broken.

However, in the structure of present invention this weak portion is strengthened by the interconnector and also no stress is imposed thereon. In addition, the area of the parallel wall left by the interconnector to define the channel is smaller in height. This means that the parallel wall of the protuberances of the present invention receives less lateral stress, and thus is less apt to break. The top of the protuberance is not sharp, so no danger of hurting fingers of the handlers is anticipated. The space left by the interconnector, the channel between adjacent protuberances, can serve as a duct for solvent to flow therethrough to and from the narrow gap, in which the solder flux remains, such as the 70 micron gap between the curved lead and the associated protuberance.

The above-mentioned features and advantages of the present invention, together with other objects and advantages which will become apparent, will be more fully described hereinafter by way of example with reference to the accompanying drawings, in which:

FIG. 1 schematically illustrates a cross-sectional side view of a PLCC soldered on a printed circuit board.

FIG. 2 schematically illustrates a cross-sectional side view of a protuberance and its associated lead, on a enlarged scale.

FIG. 3 schematically illustrates an enlarged partial perspective view of the leads and their associated protuberances of a prior art PLCC.

FIG. 4 schematically illustrates an enlarged partial sectional side view of the protuberances and the associated cavity of injection mold for a prior art PLCC.

FIG. 5 schematically illustrates an enlarged partial sectional side view to explain the slanted walls of the protuberances of the prior art PLCC.

FIG. 6 schematically illustrates an enlarged partial perspective view of a prior art PLCC having continuous protuberance.

FIG. 7 schematically illustrates an enlarged partial perspective view of the protuberances and their associated leads of an embodiment of the present invention.

FIG. 8 schematically illustrates an enlarged sectional view of protuberances and their interconnector cut by a plane vertically crossing the tops of the protuberances of FIG. 7.

FIG. 9 schematically illustrates another embodiment of the present invention.

In the embodiment of the invention, up to about one half of the height $h_0$ of the protuberances 17, the leg portions 17-2 of the protuberances are connected by interconnectors 19 as shown in FIG. 7 and 8. The height of the interconnector 19 from the bottom surface 11-1 of the main body 11 is denoted by $H_1$ in FIG. 8. The height $H_1$ is from 1/3 to 2/3 of the height $H_0$ of the protuberance 17. The broken lines in FIG. 7 and 8 indicate the border lines between newly provided interconnectors 19 and the leg portion 17-2 of the protuberances 17 as in Fig. 3 for easy explanation, though no border line is really found on the embodiment of the present invention. The slope of the outer side of the interconnectors 19 is coplanar with the slope 20 (FIG. 2) of the outer side of the leg portion 17-2 (FIG. 7) of the protuberances. The slope of the inner side of the interconnectors 19 is coplanar with the slope 22 (FIG. 2) of the inner side of the leg portion 17-2 (FIG. 7) of the protuberances. The interconnectors 19, the protuberances 17-1, 17-2 and the main body 11 of the PLCC enclosure are homogeneously made of the plastic resin injected, hardened and ejected in a similar-to-conventional type of molding cavities at the same time by the same method as that of the prior art. The leg portions 17-2 of the protuberances are strengthened by the interconnectors 19. The side walls 27-1 facing each other of the protuberances 17-1 of the present invention are smaller in height and in area than those of the Fig. 3 protuberances. Therefore, the depth of molded protuberances into the corresponding cavities is shallow, so that the undesirable lateral stress orthogonally against these side wall caused by non-parallel motion of ejection of the molded PLCC from the molding cavities is less than that of the Fig. 3 protuberances. Thus, the probability of breakage of the protuberances is considerably reduced. The edge of the top of the protuberance 17-1 is no less than 90°. Therefore, no danger of hurting fingers of the handlers at the production process of the PLCC is anticipated. The space 18-1, i.e. the channel left by the interconnector 19 between the protuberances 17-1, can serve as a duct for solvent to flow therein to and from the narrow portion, such as the 70 $\mu$m gap 25 between the curved lead and the protuberance, so that the solvent can perfectly remove the undesirable flux remaining thereon. Washing of the soldered printed circuit board is done by boiling or dipping in a bath of the solvent. The space, the channel 18-1 left by the interconnector 19, is located adjoining this narrow gap 25 between the top 21 of the protuberance and the curved lead wherefrom the removal of the flux has not been easy. Therefore, this channel 18-1 is very effective and necessary for smooth flow of the solvent to and from the portions difficult for removal of the remaining flux. In another embodiment of the present invention, the corners 18-2 of the channel 18-1 at the connection point of the interconnector 19 and the protuberance 17-1 can be shaped round as shown in Fig. 9. Though, as stated above the lateral stress caused by non-parallel ejection is already reduced, this corner is a delicate place where the stress is concentrated and still possible to crack even though the probability is very little. In addition, this corner end of the channel 18-1 has not been fully contributing to the flow of the solvent, and rather been a place from which the remaining flux is not easily removed. Therefore, the channel having rounded corner is advantageous to provide stronger protuberance without sacrificing smooth flow of the solvent.

The many features and advantages of the invention are apparent from the detailed specification. Although the invention is described with reference to preferred embodiments, it is not limited thereto.

## Claims

1. A package for encapsulating an integrated circuit comprising:
   (a) an enclosure (11 ) having said integrated circuit (13) located therein, said enclosure having a top (11-2), a bottom (11-1), and four lateral sides (23), said bottom side being provided with a plurality of protuberances (17), said protuberances being aligned along each lateral side, and being spaced from and connected to adjacent protuberances by an interconnector (19) by a predetermined distance, said interconnector being made of the same material as said enclosure, said interconnector swelling out of said bottom side and having a height from one-third to two-thirds of the height of said protuberances measured from said bottom side; and
   (b) a plurality of leads (12), a first end of each lead being connected to a terminal pad of said integrated circuit encapsulated in said enclosure, a second end of each lead extending through said each lateral side and further along said lateral side toward said bottom, and each of said second ends further extending over and curving around each of said protuberances toward said bottom side.

2. A package according to claim 1 wherein corners (18-2) between the top of said interconnectors and the sides of the adjacent protuberances are rounded.

## Revendications

1. Boîtier pour encapsuler un circuit intégré comprenant :
   (a) un boîtier (11) à l'intérieur duquel est placé le circuit intégré (13), ce boîtier ayant une partie supérieure (11-2), une partie inférieure (11-1) et quatre côtés latéraux (23), le côté inférieur étant muni d'une pluralité de protubérances (17), ces protubérances étant alignées le long de chaque côté latéral et étant espacées d'une distance prédéterminée des protubérances adjacentes et reliées à ces protubérances adjacentes par une partie intermédiaire (19), cette partie intermédiaire étant réalisée dans le même matériau que le boîtier et se projetant en dehors du côté inférieur et ayant une hauteur comprise entre un tiers et deux tiers de la hauteur des protubérances mesurée depuis le côté inférieur ; et
   (b) une pluralité de broches de connexion (12), une première extrêmité de chaque broche de connexion étant connectée à un plot du circuit intégré encapsulé dans le boîtier, une seconde extrêmité de chaque broche de connexion traversant chaque côté latéral et s'étendant en outre le long du côté latéral jusqu'à la partie inférieure, et chacune des secondes extrêmités s'étendant également sur chacune des protubérances et étant incurvées autour de chacune de ces protubérances jusqu'aux côtés inférieurs.

2. Boîtier selon la revendication 1, dans lequel des coins (18-2) situés entre la partie supérieure des parties intermédiaires et les côtés des protubérances adjacentes sont arrondis.

## Ansprüche

1. Packung für die Kapselung einer integrierten Schaltung mit:
   (a) einem Gehäuse (11), in dem die integrierte Schaltung (13) angeordnet ist, welches Gehäuse eine Oberseite (11-2), eine Unterseite (11-1), und vier seitliche Wände (23) hat, welche Unterseite mit einer Vielzahl von Vorsprüngen (17) versehen sind, welche Vorsprünge längs jeder Seitenwand ausgerichtet sind, mit Abstand voneinander angeordnet und mit benachbarten Vorsprüngen durch einen Zwischenverbinder (19) über eine vorbestimmte Distanz verbunden sind, welcher Zwischenverbinder aus demselben Material wie das Gehäuse besteht, wobei der Zwischenverbinder aus der genannten Unterseite herausschwillt und eine Höhe von einem Drittel bis zwei Drittel der Höhe der genannten Vorsprünge hat, gemessen von der Unterseite; und
   (b) einer Vielzahl von Leitungen (12), wobei ein erstes Ende von jeder Leitung mit einem Anschlußkissen der genannten integrierten Schaltung verbunden ist, die in dem genannten Gehäuse eingekapselt ist, und wobei ein zweites Ende von jeder Leitung sich durch jede genannte Seitenwand und ferner längs der genannten Seitenwand zu dem genannten Boden erstreckt, und jedes der zweiten Enden sich ferner über jeden der genannten Vorsprünge erstreckt und sich um diese zu der genannten Bodenseite krümmt.

2. Packung nach Anspruch 1, bei der die Ecken (18-2) zwischen der Oberseite der genannten Zwischenverbinder und den Seiten der benachbarten Vorsprünge abgerundet sind.

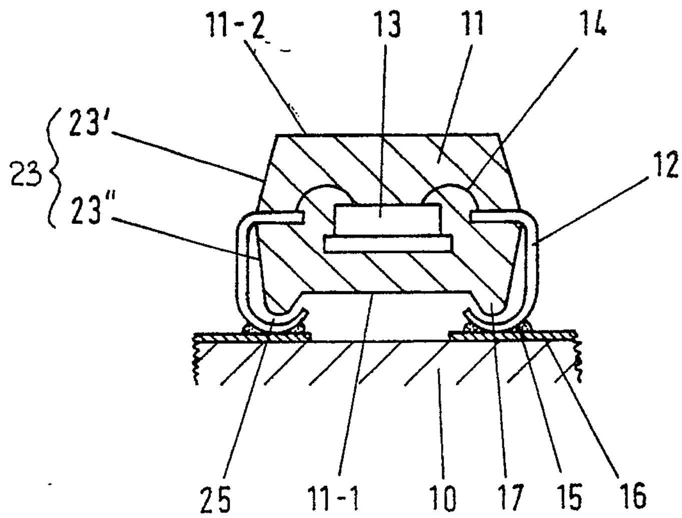
11-2
13
11
14
23'
23
23"
12
25
11-1
10
17
15
16

FIG. 1

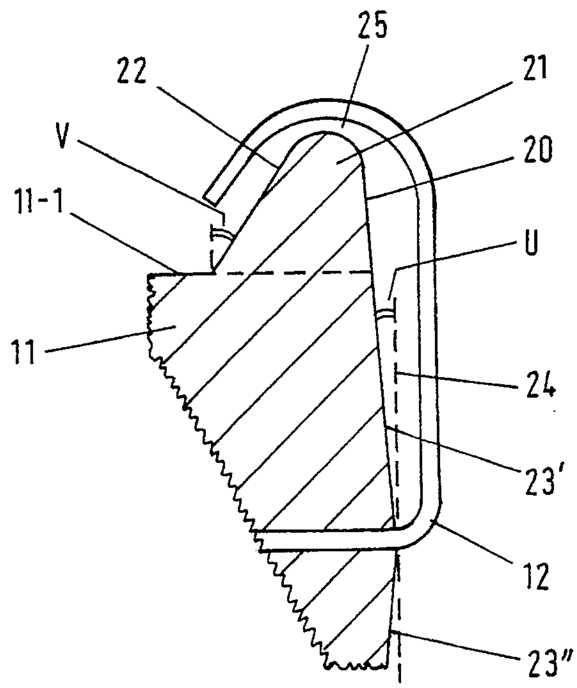
25
22
21
V
20
11-1
U
11
24
23'
12
23"

FIG. 2

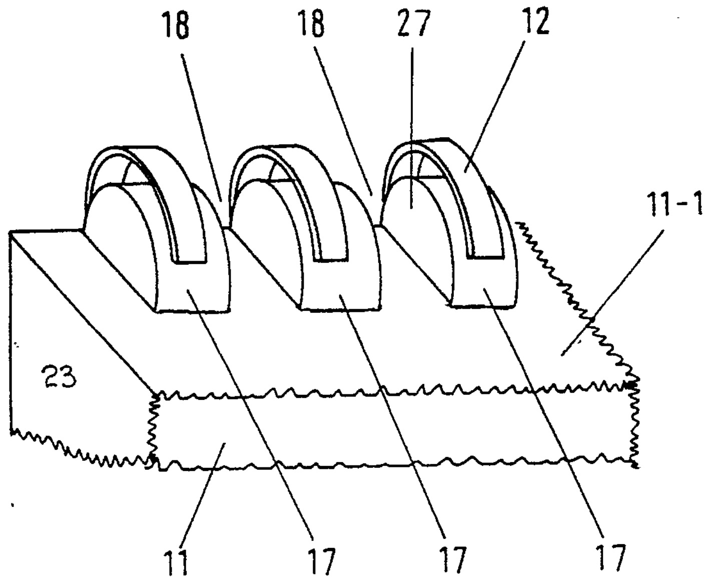


FIG. 3

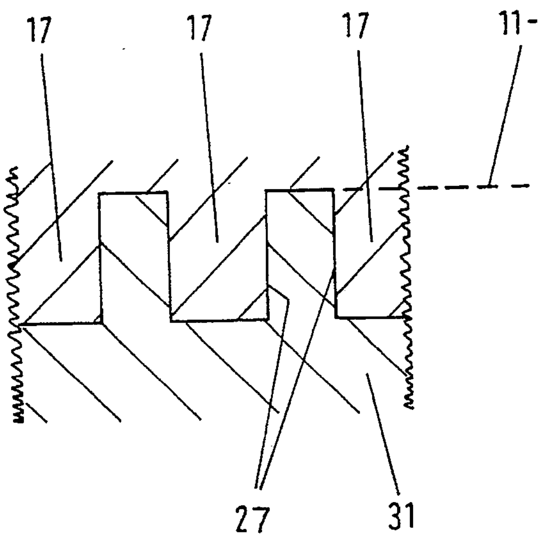


FIG. 4

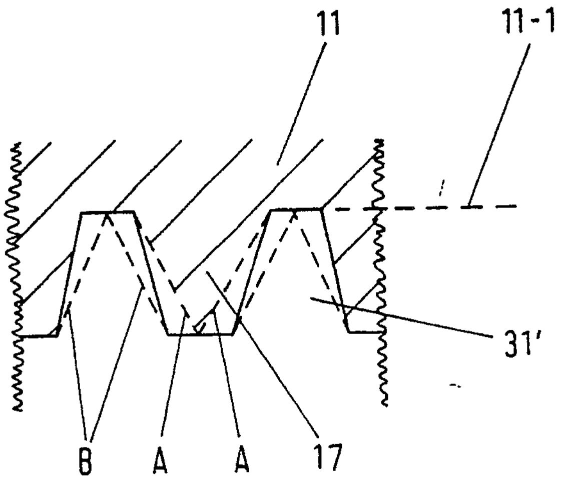


FIG. 5

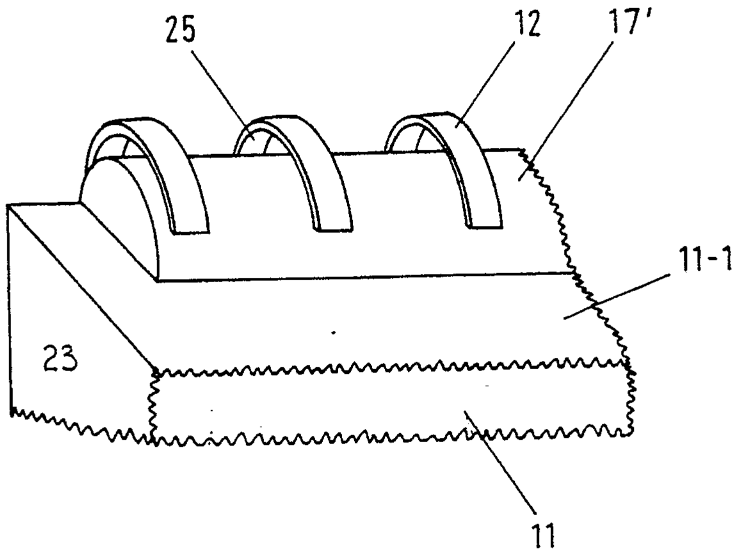


FIG. 6

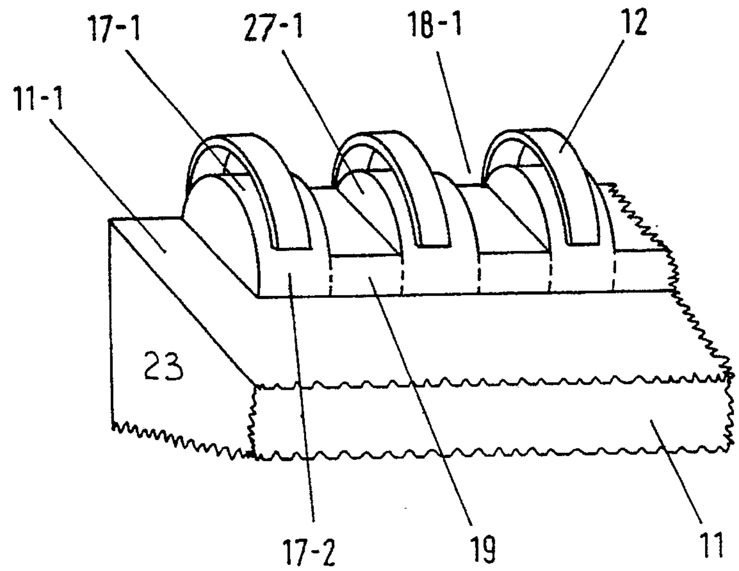
17-1
27-1
18-1
12
11-1
23
17-2
19
11

FIG. 7

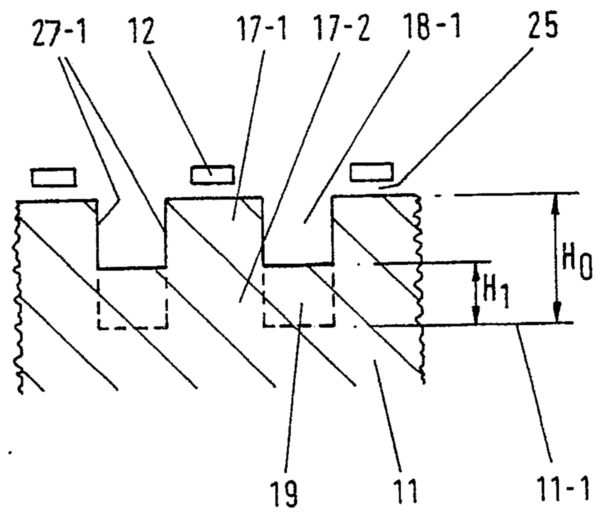
27-1
12
17-1
17-2
18-1
25
H0
H1
19
11
11-1

FIG. 8

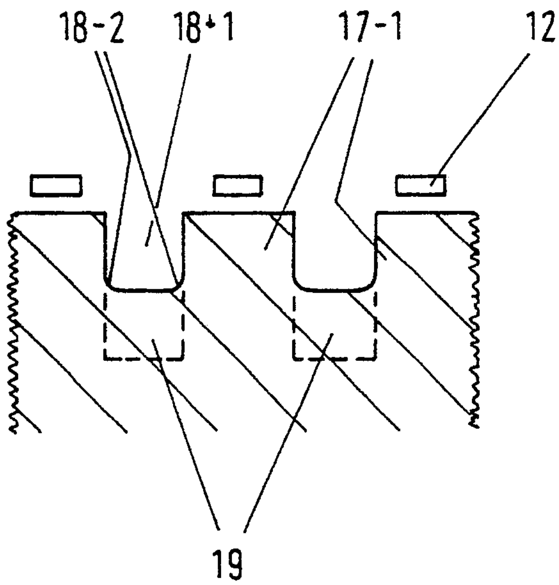


FIG. 9